# EUROPÄISCHE PATENTSCHRIFT

(11) **EP 0 868 751 B1**
(45) Veröffentlichungstag und Bekanntmachung des Hinweises auf die Patenterteilung: **26.02.2003**
(21) Anmeldenummer: 96946111.0
(22) Anmeldetag: 20.12.1996
(51) Int. Cl.: H01L 31/02

(54) **OPTOELEKTRONISCHES SENSOR-BAUELEMENT**
OPTO-ELECTRONIC SENSOR COMPONENT
CAPTEUR OPTOELECTRONIQUE

(30) Priorität: 21.12.1995 DE 19549228
(43) Veröffentlichungstag der Anmeldung: 07.10.1998
(73) Patentinhaber: Dr. Johannes Heidenhain GmbH, 83301 Traunreut (DE); Silicon Sensor GmbH, 12459 Berlin (DE)
(72) Erfinder: HOFBAUER, Hermann, D-83308 Trostberg (DE); KRIEGEL, Bernd, D-12459 Berlin (DE); SPECKBACHER, Peter, D-84558 Kirchweidach (DE); ULLRICH, Martin, D-83324 Ruhpolding (DE); DIETL, Rupert, D-84549 Engelsberg (DE)
(74) Vertreter: Ninnemann, Detlef, Dipl.-Ing.
(86) Internationale Anmeldenummer: DE9602478
(87) Internationale Veröffentlichungsnummer: WO97023897

(56) Entgegenhaltungen:
- EP-A- 0 452 588
- EP-A- 0 464 232
- DE-A- 4 228 274
- US-A- 4 897 123
- US-A- 5 075 238
- PATENT ABSTRACTS OF JAPAN vol. 012, no. 291 (E-644), 9.August 1988 & JP 63 066964 A (OLYMPUS OPTICAL CO LTD), 25.März 1988,
- PATENT ABSTRACTS OF JAPAN vol. 007, no. 214 (E-199), 21.September 1983 & JP 58 107788 A (MITSUBISHI DENKI KK), 27.Juni 1983,

## Beschreibung

Die Erfindung betrifft eine optoelektronisches Sensor-Bauelement nach dem Oberbegriff des Anspruchs 1.

Optoelektronische Sensor-Bauelemente sind Strahlungsempfänger, die elektromagnetische Strahlungsenergie (Photonen) in elektrische Signale umwandeln und in der Meßtechnik von großer Bedeutung sind. Beispielsweise werden in Positionsmeßsystmen, wie Längen- und Winkelmeßsystemen (inkrementaler oder absoluter Art) hinter einer Gitterstruktur mehrere Strahlungsempfänger (insbesondere Fotoelemente) angeordnet.

Derartige Strahlungsempfänger sind in der Regel als Sperrschicht-Fotodetektoren ausgebildet. Sie enthalten einen PN-, PIN-, MS- oder MOS-Übergang, in dem die Umwandlung elektromagnetischer Strahlungsenergie in ein elektrisches Signal mittels des Fotosperrschichteffektes erfolgt. Um das elektrische Signal messen und auswerten zu können, muß der Strahlungsempfänger mit elektrischen Kontakten versehen sein und an eine geeignete elektrische Schaltung angeschlossen werden. Diese Integration in eine elektrische Schaltung erfolgt häufig auf einer Leiterplatte. Die Strahlungsempfänger werden dementsprechend vorzugsweise als SMD-Bauelemente (Surface Mounted Devices) ausgebildet.

Aus der EP 0 464 232 B1 ist ein Lötverbinder für elektronische Bauelemente bekannt. Dieser kann zur Integration mehrerer Fotelemente in eine elektrische Schaltung verwendet werden. Die Fotoelemente sind beispielsweise mit ihren als Kontaktflächen ausgebildeten metallisierten Rückseiten auf einer Leiterplatte befestigt. Der Lötverbinder weist mehrere Lötbrücken auf und dient zum Anschluß der auf der Vorderseite der Fotoelemente angeordneten zweiten Kontakte an entsprechende Leiterbahnen der Leiterplatte. Die Lötbrücken sind derartig mit Sollbruchstellen und Biegekanten versehen, daß die Herstellung der gewünschten elektrischen Schaltung erleichtert wird. Wegen der beengten Platzverhältnisse auf einer Leiterplatte erweist sich jedoch trotz dieser Maßnahmen das Herstellen von Lötverbindungen häufig als schwierig.

Ein Verfahren zur Kontaktierung von auf einem Träger befindlichen optoelektronischen Bauelementen ist auch aus der DE 42 28 274 A1 bekannt. Dabei werden die Kontakte des optoelektronischen Bauelementes, die auf der dem Träger abgewandten Seite des Bauelementes angeordnet sind, mittels auf einer Kunsstoffschicht angeordneter Leiterbahnen mit neben dem Bauelement befindlichen Anschlußflächen des Trägers verbunden. Bei Anwendung dieses Verfahrens wird der Platzbedarf eines Bauelements auf einer Leiterplatte durch den zusätzlichen Platzbedarf der Leiterbahnen einschließlich des Kunststoffträgers vergrößert.

Aus der EP 0 452 588 A1 ist eine Solarzelle bekannt, bei der auf einem Substrat eine halbleitende Schicht vom n-Typ angeordnet ist. Ein Teil der halbleitenden Schicht vom n-Typ und des Substrats wird für die Herstellung eines Einschnittes in beide Schichten weggeätzt. Auf die halbleitende Schicht vom n-Typ wird eine halbleitende Schicht vom p-Typ aufgebracht und darauf eine weitere Schicht des gleichen Leitungstyps sowie ein Antireflexionsfilm. In den Einschnitt sowie auf der halbleitenden Schicht vom p-Typ wird eine Elektrode angebracht und durch Auftrennen des Substrats ein Durchdringen der mit der halbleitenden Schicht vom p-Typ verbundenen Elektrode zur Rückseite des Bauelements geschaffen, wo die Elektrode mit einer Flächenelektrode elektrisch leitend verbunden ist.

Durch Wegätzen der oberen Schichten sowie der halbleitenden Schicht vom p-Typ und Ätzen eines Einschnitts in die halbleitende Schicht vom n-Typ sowie des verbleibenden Substrats wird eine n-seitige Elektrode geschaffen, die die halbleitende Schicht vom n-Typ mit der Rückseite des Bauelements und einer dort vorgesehenen Flächenelektrode verbindet. Bei dieser bekannten Solarzelle werden somit leitende Verbindungen zwischen den beiden halbleitenden Schichten durch eine in die Einschnitte eingebrachte elektrisch leitende Schicht geschaffen.

Aus der US-A 4,897,123 ist eine Solarzelle mit einem Halbleitersubstrat des einen Leitfähigkeits-Typs und einem Übergangsbereich des anderen Leitfähigkeits-Typs, der sich durch das Substrat erstreckt, bekannt. Eine erste halbleitende Schicht ist auf der Vorderseite des Substrats angeordnet und darauf eine zweite halbleitende Schicht mit entgegengesetztem Leitfähigkeits-Typ, so daß die beiden Schichten einen pn-Übergang bilden. Die zweite halbleitende Schicht ist mit dem Übergangsbereich verbunden, der sich von der Vorderseite zur Rückseite der Solarzelle erstreckt.

Auf der Vorderseite der Solarzelle ist eine mit der einen halbleitenden Schicht verbundene Kontaktelektrode angeordnet und auf der Rückseite der Solarzelle ist eine mit der anderen halbleitenden Schicht verbundenen Kontaktelektrode vorgesehen. Zusätzlich ist eine weitere Kontaktelektrode auf der Rückseite der Solarzelle angeordnet, die über eine elektrisch leitende Klammer mit der auf der Vorderseite angeordneten, mit der einen halbleitenden Schicht verbundenen Elektrode verbunden ist. Bei der Herstellung der bekannten Solarzelle wird in einem der Verfahrensschritte eine Verbindung von der einen halbleitenden Schicht über den Übergangsbereich zur Rückseite des Bauelements vorgenommen. An dieser Stelle wird das Bauelement durchtrennt und eine elektrische Verbindung zwischen der an der Vorderseite angeordneten Kontaktelektrode zu der auf der Rückseite des Bauelementes angeordneten Kontaktelektrode über das Verbindungselement hergestellt. Eine Verbindung über ein halbleitendes Verbindungselement, das nicht mit dem Übergangsbereich zwischen den halbleitenden Schichten übereinstimmt, ist jedoch nicht vorgesehen.

Aus der US-A-3 903 428 ist eine Solarzelle bekannt, bei der auf der Oberfläche eines Halbleiter-Wafers strahlenförmige Stromaufnahmepfade vorgesehen sind, während die Rückseite des Halbleiter-Wafers mit einer Metallschicht verbunden ist. Durch den Halbleiter-Wafer wird eine Bohrung angebracht, die mit einer Isolierschicht ausgekleidet wird. in die Bohrung wird ein Kontaktstift eingesteckt, der auf der Vorderseite einen leitenden Metallring aufweist, der mit den Stromaufnahmepfaden elektrisch leitend verbunden ist. Auf der Rückseite ragt der Kontaktstift durch die Metallschicht, so daß eine elektrisch leitende Verbindung zwischen den vorderseitigen Stromaufnahmepfaden und einem Kontakt auf der Rückseite des Halbleiter-Wafers vorgesehen ist.

Aus der US-A-3 903 427 ist eine Solarzelle bekannt, bei der in einem Wafer mehrere Bohrungen vorgesehen sind, die mit Isolationsschichten ausgekleidet sind. Eine auf der Vorderfläche der Solarzelle angeordnete Oberflächenschicht wird mit einer rückseitigen Metallschicht über Leitungen verbunden, die auf der Vorderseite mit als Metallkontakte ausgebildeten Stromaufnahmepunkten versehen sind. Die Rückseite des Wafers ist mit einem ersten Leiter verbunden, der jedoch keine elektrische Verbindung zur Rückseite der Solarzelle aufweist.

Aus der US-A-3 549 960 ist ein Halbleiter-Wafer bekannt, auf dessen dem strahlungsseitigen Oberflächenbereich gegenüberliegenden Oberfläche p- und n-Kontakte vorgesehen sind, die aus ineinandergreifenden Fingern bestehen.

Der Erfindung liegt die Aufgabe zugrunde, bei einem optoelektronischen Sensor-Bauelement der eingangs genannten Art eine einfach herzustellende Verbindung zwischen der einen halbleitenden Schicht und der Kontaktstelle auf der dem strahlungsseitigen Oberflächenbereich gegenüberliegenden Oberfläche des Bauelements mit einer störungsfreien elektronischen Struktur zu schaffen.

Diese Aufgabe wird erfindungsgemäß durch die Merkmale des Anspruchs 1 gelöst.

Die Erfindung beruht auf der Erkenntnis, daß der Anschluß eines optoelektronischen Sensor-Bauelements an eine Schaltung auf einer Leiterplatte wesentlich vereinfacht wird, wenn das Bauelement und dessen Elektroden so ausgebildet sind, daß die Kontaktstellen beider Elektroden auf einer Oberfläche (der Rückseite) des Bauelements angeordnet werden können. Ein derartiges Bauelement kann mit seiner Rückseite an eine mit geeigneten Kontaktflächen versehene Leiterplatte angeschlossen werden, ohne daß zusätzliche Drähte oder andere Verbindungselemente benötigt werden.

Durch die erfindungsgemäße Lösung wird eine Verbindung zwischen der einen halbleitenden Schicht und der Kontaktstelle auf der dem strahlungsseitigen Oberflächenbereich gegenüberliegenden Oberfläche geschaffen, die in einfacher Weise durch Ionenimplantation, Ionendiffusion oder Thermomigration hergestellt werden kann. Das halbleitende Verbindungselement schafft die Voraussetzung für eine störungsunanfällige elektronische Struktur der Verbindung zwischen der halbleitenden Schicht und der rückseitigen Kontaktstelle, die nach einem weiteren Merkmal der erfindungsgemäßen Lösung durch einen zusätzlichen halbleitenden Bereich desselben Leitungstyps um das halbleitende Verbindungselement im Bereich der Kontaktstelle weiter erhöht werden kann.

Im Unterschied zu den bekannten Bauelementen wird die Verbindung von der einen halbleitenden Schicht zu der auf der Rückseite des Bauelements angeordneten Kontaktstelle nicht mittels eines elektrisch leitenden Verbindungselements, sondern mittels eines halbleitenden Verbindungselements hergestellt, das in die Struktur des Bauelements integriert wird. Dies vereinfacht den Herstellungsprozeß, da die Verbindung bereits beim Herstellungsprozeß des Bauelements bzw. Wafers hergestellt werden kann.

Das optoelektronische Bauelement kann beispielsweise aus einer ersten halbleitenden Schicht vom n-Typ bestehen, auf der eine zweite halbleitende Schicht vom p-Typ angeordnet ist. Zwischen den beiden Schichten bildet sich eine Raumladungszone als Übergangsbereich (Sperrschicht) aus, in der die einfallende Strahlung unter Erzeugung eines Fotostroms absorbiert wird. Möglich ist aber auch ein PIN-Übergang, bei dem zwischen den beiden halbleitenden Schichten vom ersten und zweiten Leitungstyp eine eigenleitende Mittelschicht als Sperrschicht angeordnet ist.

Ebenso ist es möglich, auf einer ersten hablbleitenden Schicht eine dünne Metallschicht anzuordnen, so daß ein Schottky-Übergang entsteht. Wird zwischen der ersten halbleitenden Schicht und der zweiten metallischen Schicht zusätzlich eine Oxid-Schicht angeordnet, so erhält man eines MOS-Übergang. Auch diese Bauelemente eignen sich zum Detektieren elektromagnetischer Strahlung und zur Verwirklichung der erfindungsgemäßen Lösung.

Es sei darauf hingewiesen, daß hier unter dem Begriff Übergang bzw. Übergangsbereich jeweils der Bereich eines optoelektronischen Bauelements verstanden wird, in dem mittels des Fotoeffektes eine Umwandlung optischer Energie in eine elektrisches Signal erfolgen kann. Der Begriff wird als Oberbegriff zu den Begriffen Sperrschicht, Raumladungszone, p-n-Übergang etc. gebraucht und bezeichnet stets den gesamten Bereich des Halbleiterbauelementes, in dem absorbierte Strahlung in elektrische Signale umgewandelt wird. Dadurch werden z.B. die an die Sperrschicht angrenzenden Bereiche miterfaßt, aus denen die erzeugten Ladungsträger während Ihrer Lebensdauer in die elektrische Feldzone diffundieren können, wo die Elektronen von den Löchern getrennt werden.

Unter einem strahlungsseitigen Oberflächenbereich wird eine Oberfläche des aus der ersten und zweiten Schicht sowie dem Übergangsbereich bestehenden Kerns des Bauelements verstanden, durch die die zu detektierende Strahlung in den Übergangsbereich eindringen kann und die bei Anwendung des Bauelements als Sensor zu der zu detektierenden Strahlung hin ausgerichtet wird. Es muß sich also nicht zwingend um um eine Oberfläche des Bauelements im weiteren Sinne (zu dem auch Antireflexionsschichten, strukturierende Isolierschichten und dergl. zählen) handeln; z.B. kann auf dem strahlungsseitigen Oberflächenbereich noch eine Antireflexionsschicht angeordnet sein.

Damit die einfallende Strahlung zu einem möglichst großen Teil in den Übergangsbereich gelangt, ist zumindest eine der beiden Schichten (z. B. die zweite halbleitende Schicht) dünner als die Eindringtiefe der zu detektierenden Strahlung in dem entsprechenden Material. Die andere Schicht ist häufig dicker ausgebildet und gewährleistet die Stabilität des Bauelements. Das Bauelement wird dann im Betrieb so ausgerichtet, daß die dünnere, zweite Schicht der zu detektierenden Strahlung zugewandt ist. Es sind allerdings auch Ausführungsformen denkbar, bei denen die Strahlung durch die dickere erste Schicht in den Übergangsbereich gelangt.

Aufgrund der stabilisierenden, dickeren ersten Schicht bestehen die Sensor-Bauelemente regelmäßig im wesentlichen nur aus den beiden Schichten, zwischen denen sich der Übergangsbereich bildet; dazu kommen ggf. noch ein Antireflexionsschicht sowie dünne isolierende Schichten, die beispielsweise zur Strukturierung einer Oberfläche des Bauelements dienen. Auf ein Substrat als Träger der beiden aktiven, den Übergangsbereich bildenden Schichten kann jedoch verzichtet werden.

Dabei bedeutet das Merkmal, wonach der strahlungsseitige Oberflächenbereich zumindest teilweise durch die zweite Schicht gebildet wird, nicht zwingend, daß das Bauelement mit der zweiten Schicht abschließt; es handelt sich hierbei lediglich um eine Oberfläche des aus der ersten und zweiten Schicht sowie dem Übergangsbereich bestehenden Kerns des Bauelements. Hierauf können noch ergänzende Schichten, wie z.B. eine Antireflexionsschicht, angeordnet sein.

Die Erfindung gestattet eine besonders einfachen Aufbau des Sensor-Bauelements, wenn das halbleitende Verbindungselement die einzige leitende Verbindung zwischen der zweiten Schicht und deren Elektrode bildet und dabei durch das Bauelement selbst hindurch verläuft.

Da sich bei der Herstellung des halbleitenden Verbindungselements in der Nähe der mit den Elektroden versehenen (d.h. der zweiten Schicht gegenüberliegenden) Oberfläche des Bauelements häufig Störungen in der elektronischen Struktur ausbilden, ist es vorteilhaft, das halbleitende Verbindungselement dort mit einem zusätzlichen halbleitenden Bereich desselben Leitungstyps zu umgeben. Ein solcher zusätzlicher halbleitender Bereich kann z.B. durch Ionenimplantation oder -diffusion geschaffen werden und ermöglicht eine einwandfreie Kontaktierung der zweiten halbleitenden Schicht mit ihrer auf der anderen Seite des Bauelements angeordneten Elektrode.

Der zusätzliche halbleitende Bereich weist vorzugsweise eine solche Größe auf, daß er den gesamten störanfälligen Randbereich des Verbindungselements in der Nähe der rückseitigen Oberfläche des Bauelements abdeckt. Seine Ausdehnung parallel zur Erstreckungsrichtung des Verbindungselements beträgt typischerweise ca. 0.6 µm.

Um den Widerstand einer Anordnung zu minimieren, bei der die zweite Schicht über ein leitendes Verbindungselement mit einer Elektrode auf der anderen Seite des Bauelements verbunden ist, können in dem Bauelement mehrere (parallel verlaufende) Verbindungselemente vorgesehen sein.

Der Durchgang ist vorzugsweise zylindrisch und der den Durchgang umfassende Bereich hohlzylindrisch ausgebildet, wobei der Durchgang einen Durchmesser von 10 µm bis 150 µm hat. Die Dicke des den Durchgang umgebenden Bereiches liegt vorzugsweise zwischen 3 µm und 10 µm. Die Durchgänge können mit einem intensiven Laserstrahl und die diese umfassenden dotierten Bereiche durch Diffusion hergstellt werden.

Bei einer anderen vorteilhaften Variante erstreckt sich mindestens ein halbleitender Kanal von der zweiten Schicht zu der dem strahlungsseitigen Oberflächenbereich gegenüberliegenden Oberfläche des Bauelements erstreckt, der denselben Leitungstyp wie die zweite Schicht aufweist und eine Kontaktierung der zweiten Schicht auf der Rückseite des Bauelements ermöglicht.

Ein halbleitender Kanal mit einem Durchmesser der Querschnittsfläche von ca. 5 µm bis 150 µm, vorzugsweise von 30 µm bis 80 µm , kann dann beispielsweise mittels Thermomigration von Dotierungsstoffen in dem Bauelement erzeugt werden. Weitere Erläuterungen zur Thermomigration finden sich bei der Beschreibung von Ausführungsbeispielen der Erfindung anhand der Figuren.

Gemäß einer anderen Ausführungsform der Erfindung, bei der der strahlungsseitige Oberflächenbereich des Bauelements zumindest teilweise durch eine Oberfläche der zweiten Schicht gebildet wird, ist bei der dem strahlungsseitigen Oberflächenbereich abgewandten Oberfläche des Bauelements ein zusätzlicher Bereich mit dem Leitungstyp der zweiten Schicht vorgesehen.

Ferner ist es möglich, daß die erste (halbleitende) Schicht aus einem Material mit einer so großen Bandlücke (z. B. Siliziumkarbid) besteht, daß die zu detektierende Strahlung auch durch die der zweiten Schicht gegenüberliegende Oberfläche des Bauelements in den Übergangsbereich (Sperrschicht) eindringen kann. Ein solches optoelektronisches Sensor-Bauelement erlaubt neben der Vordereinstrahlung (durch die zweite Schicht hindurch) auch eine effiziente Rückeinstrahlung (durch die erste Schicht hindurch).

Die Erfindung läßt sich auch auf Bauelemente vorteilhaft anwenden, die mehrere unabhängige Übergangsbereiche (z.B. PN-Übergänge) und somit mehrere strahlungsempfindliche Oberflächenbereiche aufweisen. Dabei kann es sich sowohl um ein einstückiges Halbleiterbauelement mit mehreren Übergangsbereichen (monolithisches Array) als auch um ein aus mehreren Bauelementen bestehendes Hybrid-Array handeln. Jedem Übergangsbereich ist ein Elektrodenpaar zugeordnet, dessen Kontaktstellen auf einer Seite des Bauelements liegen.

Ferner läßt sich die vorliegende Erfindung bei Bauelementen besonders vorteilhaft anwenden, bei denen die Elektroden der beiden den Übergangsbereich bildenden Schichten auf einer Oberfläche des Bauelements angeordnet sind, die durch eine der beiden Schichten selbst gebildet bzw. definiert wird. Hierunter fallen auch solche Bauelemente, bei denen die mit den Elektroden versehene Schicht noch eine dünne Antireflexionsschicht, eine dünnen Isolatorschicht zur Strukturierung der Oberfläche oder dergl. aufweist, nicht jedoch solche Bauelemente, bei denen die mit denen Elektroden versehene Schicht ein die gesamte Anordnung tragendes (isolierendes oder halbleitendes) Susbtrat bildet.

Schließlich ist es vorteilhaft, wenn die Kontaktstellen der Schichten aus einem lötfähigen und/oder drahtbondfähigen und/oder leitklebefähigen Material bestehen.

Weitere Vorteile der Erfindung werden bei der nachfolgenden Erläuterung von Ausführungsbeispielen anhand der Figuren deutlich werden.

Es zeigen:
- Figur 1 -: ein Ausführungsbeispiel des erfindungsgemäßen optoelektronischen Sensor-Bauelements mit einem hohlzylindrischen, halbleitenden Verbindungselement von der Vorderseite zur Rückseite des Bauelementes und
- Figur 2 -: ein Ausführungsbeispiel mit einem zylindrischen, halbleitenden Verbindungselement von der Vorderseite zur Rückseite des Bauelements.

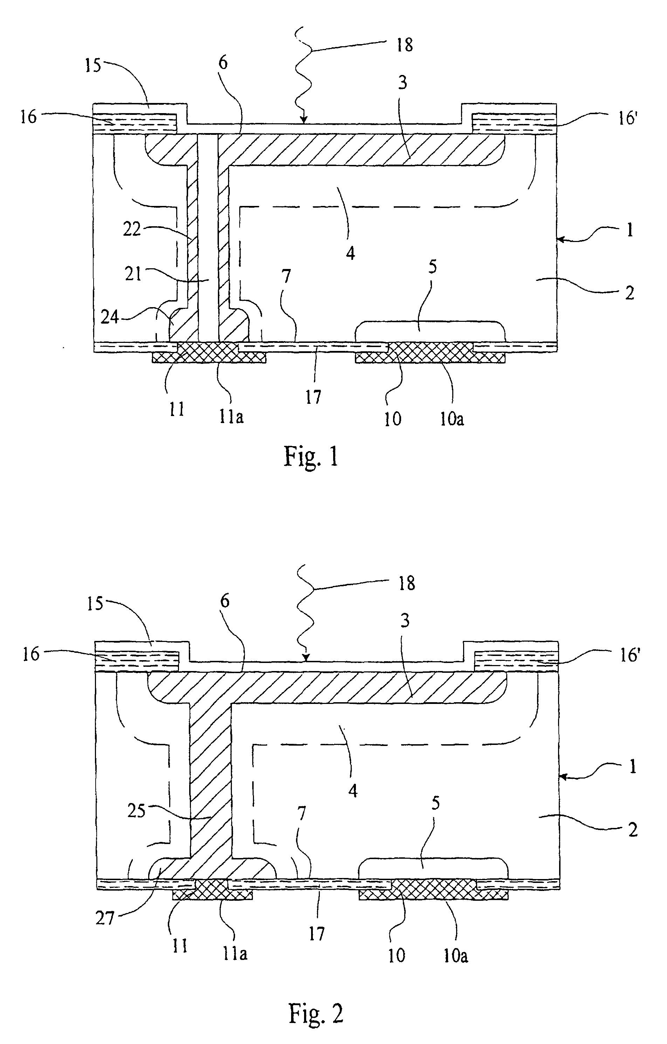

In Figur 1 ist ein erstes Ausführungsbeispiel des erfindungsgemäßen optoelektronischen Sensor-Bauelements dargestellt. Der halbleitende Grundkörper des Bauelements 1 besteht beispielsweise aus Silizium und umfaßt eine breite n-leitende Schicht 1 (300 µm bis 400 µm dick), an deren vorderer Oberfläche sich eine wesentlich dünnere p-leitende Schicht 3 (ca. 0.55 µm dick) erstreckt. Zwischen den beiden halbleitenden Schichten 2, 3 bildet sich eine Raumladungszone 4 (Verarmungszone) aus, die als Sperrschicht wirkt.

Die Vorderseite des Bauelements 1 ist mit einer Antireflexionsschicht 15 versehen und wird durch isolierende Schichten 16 und 16' strukturiert, die z. B. aus Siliziumdioxid bestehen können. Zwischen den beiden isolierenden Schichten 16, 16' erstreckt sich der strahlungsseitige Oberflächenbereich 6, der durch eine Oberfläche der p-leitenden Schicht 3 gebildet wird.

Auf den Oberflächenbereich 6 auftreffende elektromagnetische Strahlung 18 gelangt durch die p-leitende Schicht 3 in die Raumladungszone 4 und wird dort zu einem großen Teil absorbiert. Dabei entstehen in der Raumladungszone 4 Elektron-Lochpaare. Das Raumladungsfeld trennt diese Trägerpaare; Elektronen fließen zur n-, Löcher zur p-Seite. Um diesen Fotostrom, der ein Maß für die einfallende Strahlungsleistung ist, messen zu können, muß das Bauelement 1 in eine geeignete elektrische Schaltung integriert werden. Häufig umfaßt eine solche elektrische Schaltung mehrere Fotoelemente und weitere halbleitende Bauelemente, die gemeinsam auf einer Leiterplatte angeordnet werden.

Zum Anschluß des Bauelements 1 an eine derartige elektrische Schaltung sind auf dessen durch isolierende Schichten 17 strukturierter rückseitiger Oberfläche 7 Elektroden 10 und 11 mit flächigen Kontaktstellen 10a und 11a aus lötfähigem Material vorgesehen. Die rückseitige Oberfläche 7 wird dabei durch durch eine Oberfläche der n-leitenden Schicht 2 selbst gebildet.

Die Anschlußelektrode 10 der n-leitenden Schicht 2 ist an einem niederohmigen, stark dotierten Bereich 5 der halbleitenden Schicht 2 angeordnet, um den Kontaktwiderstand zu minimieren.

Um die Anschlußelektrode 11 der p-leitenden Schicht 3 ebenfalls an der rückseitigen Oberfläche 7 des Bauelements 1 anordnen zu können, erstreckt sich ein zylindrischer Durchgang 21 mit einem Durchmesser von ungefähr 100 µm von dem strahlungsseitigen Oberflächenbereich 6 des Bauelementes 1 bis zu dessen Rückseite. Der Durchgang 21 ist auf seiner gesamten Länge vollständig von einem hohlzylindrischen, p-leitenden Bereich 22 mit einer Dicke von 3 µm bis 10 µm umgeben. Die Anschlußelektrode 11 der p-leitenden Schicht 3 ist an dem rückseitigen Ende des Durchgangs 21 neben der Elektrode 10 der n-leitenden Schicht 2 angeordnet.

Das rückseitige Ende des Durchgangs 21 ist außerdem von einem zusätzlichen p-leitenden Bereich 24 umgeben, der z.B. durch Ionenimplantation oder -diffusion hergestellt werden kann und der eine einwandfreie Kontaktierung der p-leitenden Schicht 3 über den hohlzylindrischen Bereich 22 und die Elektrode 11 ermöglicht. Die Ausdehnung des zusätzlichen p-leitenden Bereichs 24 wird derart gewählt, daß er den oberflächennahen Abschnitt des hohlzylindrischen Bereichs 22 soweit umschließt, daß die bei der Herstellung des hohlzylindrischen Bereichs 22 in Oberflächennähe auftretenden Störungen in der elektronischen Struktur möglichst weitgehend eliminiert werden. Die Dicke des zusätzlichen p-leitenden Bereichs (Ausdehnung parallel zur Erstreckungsrichtung des Durchgangs 21) liegt in der Größenordnung von 0.6 µm.

Der Durchgang 21 selbst kann mittels eines intensiven Laserstrahls erzeugt werden. Aufgrund dieses Durchganges 21 ist es problemlos möglich, den p-leitenden Bereich 22 des Bauelements 1 so auszubilden, daß er sich durch die 300 µm bis 400 µm dicke n-leitende Schicht 2 hindurch bis zur Rückseite des Bauelements 1 erstreckt. Ohne den Durchgang 21 wäre der Abstand zwischen der p-leitenden Schicht 3 und der rückseitigen Oberfläche 7 des Bauelements 1 zu groß, um mit herkömmlichen Diffusionsverfahren überbrückt zu werden; typischerweise dauert es nämlich mehrere Stunden, um Dotierungsstoffe mittels Diffusion etwa 10 µm tief in eine halbleitende Schicht eindiffundieren zu lassen. In dem vorliegenden Fall wird ein die geeigneten Dotierungsstoffe enthaltendes Gas in den Durchgang 21 eingeleitet, so daß die Dotierungsstoffe in die Wandung des Durchgangs 21 eindringen und den hohlzylindrischen, p-dotierten Bereich 22 bilden. Der zusätzliche p-leitende Bereich 24 wird bevorzugt nach Fertigstellung des hohlzylindrischen Bereichs 22 geschaffen.

Um bei der vorliegenden Ausführungsform der Erfindung den Widerstand der Anode zu minimieren, können sich mehrere hohlzylindrische, p-leitende Bereiche 22 von der p-leitenden Schicht 3 zu der Rückseite 7 des Bauelements 1 erstrekken und dort mit einer Kontaktstelle in Verbindung stehen.

Aufgrund der auf der rückseitigen Oberfläche 7 des Bauelements 1 nebeneinander liegenden Elektroden 10 bzw. 11 der n-leitenden Schicht 2 und der p-leitenden Schicht 3 läßt sich das Bauelement 1 sehr einfach an eine Leiterplatte anschließen und dadurch in eine elektrische Schaltung integrieren. Dazu müssen lediglich die Elektroden 10 und 11 mit ihren Kontaktstellen 10a und 11a auf dafür vorgesehene Kontaktflächen der Leiterplatte aufgesetzt und durch Löten oder Ultraschallschweißen befestigt werden. Zusätzliche Verbindungselemente, wie z.B. Lötbrücken, zwischen den Elektroden des Bauelementes 1 und der Leiterplatte sind nicht notwendig.

Ein zweites Ausführungsbeispiel der Erfindung ist in Figur 2 dargestellt. Es unterscheidet sich von der in Figur 1 dargestellten Ausführungsform lediglich hinsichtlich der Ausbildung der Verbindung zwischen der p-leitenden Schicht 3 und der mit den Elektroden 10, 11 rückseitigen Oberfläche 7 des Bauelements 1.

Gemäß dem Ausführungsbeispiel in Figur 2 erstreckt sich ein zylindrischer, halbleitender Kanal 25 vom p-Typ zwischen der p-leitenden Schicht 3 und der rückseitigen Oberfläche 7 des Bauelements 1. Der p-leitende Kanal 25 hat vorzugsweise einen Durchmesser von 30 µm bis 100 µm und läßt sich mittels Thermomigration herstellen.

Das Prinzip der Thermomigration beruht darauf, daß die Löslichkeit metallischer Dotierungsstoffe in halbleitenden Materialien, wie z.B. Silizium, temperaturabhängig ist und mit steigender Temperatur zunimmt. Wird zwischen zwei gegenüberliegenden Oberflächen eines hinreichend erwärmten Halbleiterbauelementes ein Temperaturgradient erzeugt und auf die kühlere Oberfläche des Bauelementes ein geeigneter metallischer Dotierungsstoff aufgebracht (z.B. Aluminium zur p-Dotierung von n-leitenden Bereichen), so migriert der metallische Dotierungsstoff zu der gegenüberliegenden, wärmeren Oberfläche des Halbleiterbauelementes. Durch entsprechende Strukturierung der kühleren Oberfläche, auf die der Dotierungsstoff aufgebracht wird, z.B. mit Hilfe von Oxid-Schichten, läßt sich die Gestalt derartiger Kanäle gezielt einstellen.

Einzelheiten zu den Werten von Druck, Temperatur und anderen Parametern, bei denen die Thermomigration optimal abläuft, können der einschlägigen Literatur, beispielsweise der US-PS 3,998,764, entnommen werden.

Wie in dem Ausführungsbeispiel aus Fig. 1 ist auch hier an dem Ende des halbleitenden Kanals 25, an dem die Elektrode 11 angeordnet ist, ein zusätzlicher p-leitender Bereich 27 vorgesehen, der den Kanal 25 umschließt und eine Dicke (in Längserstreckungsrichtung des Kanals 25) von 0.6 µm aufweist.

Wird das Sensor-Bauelement 1 aus einem halbleitenden Material mit einer hinreichend großen Bandlücke hergestellt, z. B. aus Siliziumkarbid mit einer Bandlücke von 2.2 eV bis 3.3 eV, je nach Polytyp, so können Infrarotstrahlung und ein Teil des sichtbaren Lichtes auch von der rückseitigen Oberfläche 7 her durch die n-leitende Schicht 2 hindurch in die Sperrschicht 4 eindringen. Denn aufgrund der großen Bandlücke wirkt die n-leitende Schicht 2 in diesem Fall als Fenster für die genannte elektromagnetische Strahlung. Bei einer solchen Ausführung des Bauelements 1 entsteht ein Sensor, in dessen Sperrschicht 4 das Licht zur Erzeugung eines Fotostroms sowohl von der Vorderseite als auch von der Rückseite her eindringen kann.

Je nach den technischen Gegebenheiten der zugehörigen elektrischen Schaltung (Platzverhältnisse, Funktion, Zusammenwirken mit anderen Bauelementen etc.) kann das Bauelement 1 dann wahlweise entweder auf der Vorderseite oder auf der Rückseite mit den notwendigen Anschlußelektroden versehen werden. Die mit den Elektroden versehene Oberfläche des Bauelementes wird auf die Leiterplatte aufgesetzt und die gegenüberliegende Oberfläche wird zur Strahlungsquelle hin ausgerichtet.

Zusammenfassend zeigen die vorstehend erläuterten Ausführungsbeispiele, daß das erfindungsgemäße optoelektronische Sensor-Bauelement variabel gestaltet und an unterschiedliche technische Anforderungen angepaßt werden kann. Dabei wird ein einfacher Anschluß des Bauelementes an eine Leiterplatte oder dergleichen durch die gemeinsame Anordnung beider Elektroden nebeneinander auf dessen Rückseite ermöglicht.

## Patentansprüche

1. Optoelektronisches Sensor-Bauelement mit einer ersten halbleitenden Schicht (2) mit vorgegebenem Leitungstyp und einer zweiten Schicht (3) vom anderen halbleitenden Leitungstyp, einem Übergangsbereich (4) zwischen den beiden halbleitenden Schichten (2, 3), mindestens einem strahlungsseitigen Oberflächenbereich (6, 6'), durch den die zu detektierende elektromagnetische Strahlung (18) in den Übergangsbereich (4) eindringen kann, zwei Elektroden (10, 11) mit je einer an einer dem strahlungsseitigen Oberflächenbereich (6, 6') gegenüberliegenden Oberfläche (7, 7') des Bauelements (1) angeordneten Kontaktstelle (10a, 11a zum Anschluß der beiden halbleitenden Schichten (2, 3) an eine elektrische Schaltung, von denen die eine Kontaktstelle (11a) über mindenstens ein halbleitendes Verbindungselement (22, 25) mit der zweiten halbleitenden Schicht (3) verbunden und von demselben Leitungstyp wie die zweite halbleitende Schicht (3) ist,
**dadurch gekennzeichnet,**
**daß** das mindenstens eine halbleitende Verbindungselement (22, 25) die einzige leitende Verbindung zwischen der zweiten Schicht (3) und deren Elektrode (11) bildet.

2. Bauelement nach Anspruch 1, **dadurch gekennzeichnet, daß** der Leitungstyp der ersten halbleitenden Schicht (2) der n-Typ und der Leitungstyp der zweiten halbleitenden Schicht (3) und des halbleitenden Verbindungselements (22, 25) der p-Typ ist.

3. Bauelement nach Anspruch 1 oder 2, **dadurch gekennzeichnet, daß** das halbleitende Verbindungslement (22, 25) an seinem dem strahlungsseitigen Oberflächenbereich (6) gegenüberliegenden Ende von einem zusätzlichen halbleitenden Bereich (24, 27) desselben Leitungstyps umgeben ist.

4. Bauelement nach mindestens einem der vorangehenden Ansprüche, **dadurch gekennzeichnet, daß** sich in dem Bauelement (1) mehrere halbleitende Verbindungselemente (22, 25) von der zweiten halbleitenden Schicht (3) zu der dem strahlungsseitigen Oberflächenbereich (6) gegenüberliegenden Oberfläche (7) des Bauelements (1) erstrecken.

5. Bauelement nach mindestens einem der vorangehenden Ansprüche, **dadurch gekennzeichnet, daß** sich mindestens ein Durchgang (21) von der zweiten halbleitenden Schicht (3) zu der dem strahlungsseitigen Oberflächenbereich (6) gegenüberliegenden Oberfläche (7) des Bauelements (1) erstreckt und daß ein den Durchgang (21) umfassender Bereich (22) des Bauelements (1) von demselben Leitungstyp ist wie die zweite halbleitende Schicht (3).

6. Bauelement nach Anspruch 5, **dadurch gekennzeichnet, daß** der Durchgang (21) zylindrisch ausgebildet ist, einen Durchmesser von 10 µm bis 150 µm aufweist und von einem hohlzylindrischen Bereich (22) vom Leitungstyp der zweiten halbleitenden Schicht (3) umfaßt wird.

7. Bauelement nach mindestens einem der vorangehenden Ansprüche, **dadurch gekennzeichnet, daß** sich mindestens ein halbleitender Kanal (25) von der zweiten halbleitenden Schicht (3) zu der dem strahlungsseitigen Oberflächenbereich (6) gegenüberliegenden Oberfläche (7) des Bauelements (1) erstreckt, der denselben Leitungstyp wie die zweite Schicht (3) aufweist.

8. Bauelement nach Anspruch 7, **dadurch gekennzeichnet, daß** der Kanal (25) als zylindrischer Kanal mit einem Durchmesser von 10 µm bis 150 µm ausgebildet ist.

9. Bauelement nach Anspruch 8, **dadurch gekennzeichnet, daß** der Kanal (25) einen Durchmesser von 30 µm bis 80 µm aufweist.

10. Bauelement nach mindestens einem der vorangehenden Ansprüche, **dadurch gekennzeichnet, daß** sich die zweite halbleitende Schicht (3) zumindest bis zu einem der seitlichen Ränder (12, 12') der strahlungsseitigen Oberfläche des Bauelements (1) erstreckt.

11. Bauelement nach mindestens einem der vorangehenden Ansprüche, **dadurch gekennzeichnet, daß** die Dicke (d) der zweiten halbleitenden Schicht (3) kleiner ist als die Eindringtiefe der zu detektierenden Strahlung und daß der strahlungsseitige Oberflächenbereich (6) zumindest teilweise durch die zweite halbleitende Schicht (3) gebildet wird.

12. Bauelement nach mindestens einem der vorangehenden Ansprüche, **dadurch gekennzeichnet, daß** die erste halbleitende Schicht (2) aus einem Material mit einer so großen Bandlücke besteht, daß die zu detektierende Strahlung (18) auch durch die der zweiten halbleitenden Schicht (3) gegenüberliegende Oberfläche (7) des Bauelements (1) in den Übergangsbereich (4) eindringen kann.

13. Bauelement nach mindestens einem der vorangehenden Ansprüche, **dadurch gekennzeichnet, daß** es mindestens zwei unabhängige Übergangsbereiche (4) aufweist oder in Kombination mit weiteren Bauelementen (1) bildet, wobei jedem Übergangsbereich (4) ein strahlungsseitiger Oberflächenbereich (6) zugeordnet ist und die Kontaktstellen (10a, 11a) der Kontaktelemente (10, 11) entlang einer Ebene (7, 7') angeordnet sind.

14. Bauelement nach Anspruch 13, **dadurch gekennzeichnet, daß** eine regelmäßige Anordnung (Array) von Übergangsbereichen (4) vorgesehen ist.

15. Bauelement nach mindestens einem der vorangehenden Ansprüche, **dadurch gekennzeichnet, daß** die Elektroden (10, 11) beider Schichten (2, 3) auf einer Oberfläche (7, 7') des Bauelements (1) angeordnet sind, die durch eine der Schichten (2, 3) selbst definiert wird.

16. Bauelement nach mindestens einem der vorangehenden Ansprüche, **dadurch gekennzeichnet, daß** die Kontaktstellen (10a, 11a) der Schichten (2, 3) aus einem lötfähigen Material bestehen.

17. Bauelement nach mindestens einem der vorangehenden Ansprüche, **dadurch gekennzeichnet, daß** die Kontaktstellen (10a, 11a) der Schichten (2, 3) aus einem leitklebefähigen Material bestehen, mit dem eine galvanische Verbindung zu einem Bauteilträger mittels elektrisch leitendem Kleber hergestellt werden kann.

18. Bauelement nach mindestens einem der vorangehenden Ansprüche, **dadurch gekennzeichnet, daß** die Kontaktstellen (10a, 11a) der Schichten (2, 3) aus einem drahtbondfähigen Material bestehen.

19. Bauelement nach mindestens einem der Ansprüche 16 bis 18, **dadurch gekennzeichnet, daß** die Kontaktstellen (10a, 11a) der Schichten (2, 3) aus einem Material bestehen, das sowohl lötfähig als auch leitklebe- und drahtbondfähig ist.

## Claims

1. Optoelectronic sensor component having a first semiconducting layer (2) having a predetermined conduction type and a second layer (3) of the other semiconducting conduction type, a junction region (4) between the two semiconducting layers (2, 3), at least one radiation-side surface region (6, 6'), through which the electromagnetic radiation (18) to be detected can penetrate into the junction region (4), two electrodes (10, 11) each having a contact point (10a, 11a), arranged at a surface (7, 7') of the component (1) opposite to the radiation-side surface region (6, 6'), for the connection of the two semiconducting layers (2, 3) to an electrical circuit, one contact point (11a) of which is connected to the second semiconducting layer (3) via at Least one semiconducting connecting element (22, 25) and is of the same conduction type as the second semiconducting layer (3),
**characterized**
**in that** the at least one semiconducting connecting element (22, 25) forms the sole conducting connection between the second layer (3) and the electrode (11) thereof.

2. Component according to Claim 1, **characterized in that** the conduction type of the first semiconducting layer (2) is the n-type and the conduction type of the second semiconducting layer (3) and of the semiconducting connecting element (22, 25) is the p-type.

3. Component according to Claim 1 or 2, **characterized in that** the semiconducting connecting element (22, 25) is surrounded by an additional semiconducting region (24, 27) of the same conduction type at its end opposite to the radiation-side surface region (6).

4. Component according to at least one of the preceding claims, **characterized in that**, in the component (1), a plurality of semiconducting connecting elements (22, 25) extend from the second semiconducting layer (3) to the surface (7) of the component (1) opposite to the radiation-side surface region (6).

5. Component according to at least one of the preceding claims, **characterized in that** at least one passage (21) extends from the second semiconducting layer (3) to the surface (7) of the component (1) opposite to the radiation-side surface region (6), and **in that** a region (22) of the component (1) that encompasses the passage (21) is of the same conduction type as the second semiconducting layer (3).

6. Component according to Claim 5, **characterized in that** the passage (21) is of cylindrical design, has a diameter of 10 µm to 150 µm and is encompassed by a hollow-cylindrical region (22) of the conduction type of the second semiconducting layer (3).

7. Component according to at least one of the preceding claims, **characterized in that** at least one semiconducting channel (25) extends from the second semiconducting layer (3) to the surface (7) of the component (1) opposite to the radiation-side surface region (6), which channel has the same conduction type as the second layer (3).

8. Component according to Claim 7, **characterized in that** the channel (25) is designed as a cylindrical channel with a diameter of 10 µm to 150 µm.

9. Component according to Claim 8, **characterized in that** the channel (25) has a diameter of 30 µm to 80 µm.

10. Component according to at least one of the preceding claims, **characterized in that** the second semiconducting layer (3) extends at least as far as one of the lateral edges (12, 12') of the radiation-side surface of the component (1).

11. Component according to at least one of the preceding claims, **characterized in that** the thickness (d) of the second semiconducting layer (3) is less than the penetration depth of the radiation to be detected, and **in that** the radiation-side surface region (6) is at least partly formed by the second semiconducting layer (3).

12. Component according to at least one of the preceding claims, **characterized in that** the first semiconducting layer (2) is composed of a material with such a large band gap that the radiation (18) to be detected can also penetrate through the surface (7) of the component (1) opposite to the second semiconducting layer (3) into the junction region (4).

13. Component according to at least one of the preceding claims, **characterized in that** it has at least two independent junction regions (4), or forms them in combination with further components (1), each junction region (4) being assigned a radiation-side surface region (6) and the contact points (10a, 11a) of the contact elements (10, 11) being arranged along a plane (7, 7').

14. Component according to Claim 13, **characterized in that** a regular arrangement (array) of junction regions (4) is provided.

15. Component according to at least one of the preceding claims, **characterized in that** the electrodes (10, 11) of the two layers (2, 3) are arranged on a surface (7, 7') of the component (1) which is defined by one of the layers (2, 3) itself.

16. Component according to at least one of the preceding claims, **characterized in that** the contact points (10a, 11a) of the layers (2, 3) are composed of a solderable material.

17. Component according to at least one of the preceding claims, **characterized in that** the contact points (10a, 11a) of the layers (2, 3) are composed of a conductive-adhesive material with which a direct electrical connection to a component carrier can be produced by means of electrically conductive adhesive.

18. Component according to at least one of the preceding claims, **characterized in that** the contact points (10a, 11a) of the layers (2, 3) are composed of a wire-bondable material.

19. Component according to at least one of Claims 16 to 18, **characterized in that** the contact points (10a, 11a) of the layers (2, 3) are composed of a material which is both solderable and conductive-adhesive and wire-bondable.

## Revendications

1. Composant capteur optoélectronique équipé d'une première couche (2) semi-conductrice avec un type de conduction prédéfini et d'une deuxième couche (3) de l'autre type de conduction semi-conducteur, d'une zone de transition (4) entre les deux couches (2, 3) semi-conductrices, d'au moins une zone de surface (6, 6') côté rayonnement, par laquelle le rayonnement électromagnétique (18) électromagnétique à détecter peut pénétrer dans la zone de transition (4), de deux électrodes (10, 11) présentant chacune un point de contact (10a, 11a) disposé sur une surface (7, 7'), opposée à la zone de surface (6, 6') côté rayonnement, du composant (1) pour le raccordement des deux couches (2, 3) semi-conductrices à un circuit électrique, dont un point de contact (11a) est relié à la deuxième couche (3) semi-conductrice au moyen d'au moins un élément de liaison (22, 25) semi-conducteur et du même type de conduction que la deuxième couche (3) semi-conductrice,
**caractérisé,**
**en ce que** le au moins un élément de liaison (22, 25) semi-conducteur forme la seule liaison conductrice entre la deuxième couche (3) et son électrode (11).

2. Composant selon la revendication 1, **caractérisé en ce que** le type de conduction de la première couche (2) semi-conductrice est le type n et le type de conduction de la deuxième couche (3) semi-conductrice et de l'élément de liaison (22, 25) semi-conducteur est le type p.

3. Composant selon la revendication 1 ou 2, **caractérisé en ce que** l'élément de liaison (22, 25) semi-conducteur est entouré sur son extrémité opposée à la zone de surface (6) côté rayonnement par une zone (24, 27) semi-conductrice supplémentaire du même type de conduction.

4. Composant selon au moins l'une des revendications précédentes, **caractérisé en ce que** plusieurs éléments de liaison (22,25) semi-conducteurs s'étendent dans le composant (1) de la deuxième couche (3) semi-conductrice à la surface (7) opposée à la zone de surface (6) côté rayonnement, du composant (1).

5. Composant selon au moins une des revendications précédentes, **caractérisé en ce qu'**au moins un passage (21) s'étend de la deuxième couche (3) semi-conductrice à la surface (7) opposée à la zone de surface (6) côté rayonnement du composant (1) et **en ce qu'**une zone (22) du composant (1) entourant le passage (21) est du même du type de conduction que la deuxième couche semi-conductrice (3).

6. Composant selon la revendication 5, **caractérisé en ce que** le passage (21) est de forme cylindrique, présente un diamètre de 10 µm à 150 µm et est entouré par une zone (22) en forme de cylindre creux du type de conduction de la deuxième couche (3) semi-conductrice.

7. Composant selon au moins l'une des revendications précédentes, **caractérisé en ce qu'**au moins un canal (25) semi-conducteur qui présente le même type de conduction que la deuxième couche (3), s'étend de la deuxième couche (3) semi-conductrice à la surface (7) opposée à la zone de surface (6) côté rayonnement du composant (1).

8. Composant selon la revendication 7, **caractérisé en ce que** le canal (25) est réalisé sous la forme d'un canal cylindrique avec un diamètre de 10 µm à 150 µm.

9. Composant selon la revendication 8, **caractérisé en ce que** le canal (25) présente un diamètre de 30 µm à 80 µm.

10. Composant selon au moins l'une des revendications précédentes, **caractérisé en ce que** la deuxième couche (3) semi-conductrice s'étend au moins jusqu'à l'un des bords (12, 12')latéraux de la surface côté rayonnement du composant (1).

11. Composant selon au moins l'une des revendications précédentes, **caractérisé en ce que** l'épaisseur (d) de la deuxième couche (3) semi-conductrice, est inférieure à la profondeur de pénétration du rayonnement à détecter et **en ce que** la zone de surface (6) côté rayonnement est formée au moins partiellement par la deuxième couche (3) semi-conductrice.

12. Composant selon au moins l'une des revendications précédentes, **caractérisé en ce que** la première couche (2) semi-conductrice est à base d'un matériau avec une bande interdite si grande que le rayonnement (18) à détecter peut pénétrer dans la zone de transition (4) également par la surface (7), opposée à la deuxième couche (3) semi-conductrice, du composant (1).

13. Composant selon au moins l'une des revendications précédentes, **caractérisé en ce qu'**il présente ou forme en combinaison avec d'autres composants (1), au moins deux zones de transition (4) indépendantes, une zone de surface (6) côté rayonnement étant attribuée à chaque zone de transition (4) et les points de contact (10a 11a) des éléments de contact (10, 11) étant disposés le long d'un plan (7, 7').

14. Composant selon la revendication 13, **caractérisé en ce qu'**il est prévu un agencement régulier (matrice) de zones de transition (4).

15. Composant selon au moins l'une des revendications précédentes, **caractérisé en ce que** les électrodes (10, 11) des deux couches (2, 3) sont disposées sur une surface (7, 7') du composant, qui est définie elle-même par l'une des couches (2, 3).

16. Composant selon au moins l'une des revendications précédentes, **caractérisé en ce que** les points de contact (10a, 11a) des couches (2, 3) sont à base d'un matériau apte au brasage.

17. Composant selon au moins l'une des revendications précédentes, **caractérisé en ce que** les points de contact (10a, 11a) des couches (2, 3) sont à base d'un matériau apte au collage conducteur, avec lequel on peu établir une liaison galvanique avec un support de composant au moyen d'une colle électroconductrice.

18. Composant selon au moins l'une des revendications précédentes, **caractérisé en ce que** les points de contact (10a, 11a) des couches (2, 3) sont à base d'un matériau apte au raccordement filaire.

19. Composant selon au moins l'une des revendications 16 à 18, **caractérisé en ce que** les points de contact (10a, 11a) des couches (2, 3) sont à base d'un matériau qui est aussi bien apte au brasage qu'au collage conducteur et au raccordement filaire.
